# EUROPÄISCHE PATENTSCHRIFT

(11) **EP 3 433 871 B1**
(45) Veröffentlichungstag und Bekanntmachung des Hinweises auf die Patenterteilung: **19.10.2022**
(21) Anmeldenummer: 17706791.5
(22) Anmeldetag: 23.02.2017
(51) Int. Cl.: H01H 71/04, H01H 9/16, H01H 33/02, H01H 47/00

(54) **VORRICHTUNG ZUR MESSUNG EINES ZUSTANDS EINES ELEKTRISCHEN SCHALTERS, ELEKTRISCHER SCHALTER UND VERFAHREN ZUR MESSUNG EINES ZUSTANDS EINES ELEKTRISCHEN SCHALTERS**
DEVICE FOR MEASURING A CONDITION OF AN ELECTRIC SWITCH, ELECTRIC SWITCH AND METHOD FOR MEASURING A CONDITION OF AN ELECTRIC SWITCH
DISPOSITIF DE MESURE D'UN ÉTAT D'UN COMMUTATEUR ÉLECTRIQUE, COMMUTATEUR ÉLECTRIQUE ET PROCÉDÉ DE MESURE D'UN ÉTAT D'UN COMMUTATEUR ÉLECTRIQUE

(30) Priorität: 24.03.2016 DE 102016105544
(43) Veröffentlichungstag der Anmeldung: 30.01.2019
(73) Patentinhaber: TDK Electronics AG, 81671 München (DE)
(72) Erfinder: HOFFMANN, Robert, 12163 Berlin (DE)
(74) Vertreter: Epping - Hermann - Fischer
(86) Internationale Anmeldenummer: PCT/EP2017/054171
(87) Internationale Veröffentlichungsnummer: WO 2017/162396

(56) Entgegenhaltungen:
- EP-A1- 2 590 199
- EP-A1- 2 682 971
- DE-A1- 10 025 276
- DE-A1-102013 110 993
- DE-A1-102014 007 459
- DE-A1-102014 119 657
- JP-A- 2015 076 231

## Beschreibung

Die vorliegende Erfindung betrifft eine Vorrichtung zur Messung eines Zustands eines elektrischen Schalters. Die Erfindung betrifft ferner einen elektrischen Schalter, beispielsweise einen Leistungsschütz bzw. ein Relais, sowie ein Verfahren zur Messung eines Zustands eines elektrischen Schalters.

Leistungsschütze bzw. Relais sind elektrisch betriebene, fernbetätigte Schalter. Sie verfügen über einen Steuerstromkreis, der einen Laststromkreis ein- und ausschalten kann. Eine mögliche Anwendung von Leistungsschützen ist das Öffnen und Trennen von Batteriestromkreisen in Kraftfahrzeugen (HEV, PHEV, BEV, etc.). Dabei werden in der Regel sowohl der Plusals auch der Minuskontakt der Batterie mit Hilfe eines Leistungsschützes getrennt. Diese Auftrennung erfolgt im Ruhezustand des Fahrzeuges, als auch im Falle einer Störung, beispielsweise bei einem Unfall. Dabei ist es die Hauptaufgabe des Leistungsschützes, das Fahrzeug spannungsfrei zu schalten und den Stromfluss zu unterbrechen.

Für den Anwender ist es von großer Bedeutung den Zustand des Schützes genau zu kennen, um im Zweifelsfall einen Austausch vornehmen zu können. Ein besonders schwerwiegender Fehlerfall, der bei einem solchen Schütz auftreten kann ist ein so genannter "Schützkleber" (engl. Stuck). In diesem Fall klebt das schließende Element durch Verschweißung während einer Aboder Zuschaltung an einem oder beiden inneren Kontakten. Dies bedeutet, dass obwohl die Versorgungsspannung des Schützes abgeschaltet wurde, keine sichere Trennung des Laststromkreises gewährleistet ist.

Aus Sicherheitsgründen ist eine Erkennung der Schaltposition der Kontakte des Leistungsschützes / des Relais daher äußerst sinnvoll. Damit kann, beispielsweise im Fall eines klebenden Kontaktes, auf das Fehlverhalten mit geeigneten Maßnahmen reagiert werden.

Das Dokument JP 2015 076231 A offenbart eine Schaltvorrichtung mit einer Monitoringeinheit, die an ein Paar feststehender Kontakte über Leitungsteile angeschlossen ist. Die Monitoringeinheit weist einen Change-Over-Switch und eine Spannungsdetektionseinheit auf, die mehrere hochohmige Widerstände aufweist.

Das Dokument DE 100 25 276 A1 offenbart eine Beschaltung für eine Schaltstrecke, mittels derer eine Lastspannung an eine Last anschaltbar ist, wobei eine Spannungserfassungsschaltung über Erfassungswiderstände mit einem eingangsseitigen und einem ausgangsseitigen Erfassungspunkt der Schaltstrecke verbunden ist, wobei die Spannungserfassungsschaltung mit den Erfassungspunkten hochohmig, aber galvanisch permanent verbunden ist.

Eine zu lösende Aufgabe besteht darin, eine Vorrichtung zur verbesserten Messung eines Zustands eines elektrischen Schalters, einen verbesserten elektrischen Schalter, insbesondere einen verbesserten Leistungsschütz bzw. ein verbessertes Relais, sowie ein verbessertes Verfahren zur Messung eines Zustands eines elektrischen Schalters anzugeben. Beispielsweise soll Zustand des Schalters - offen oder geschlossen - sicher und ohne Zuhilfenahme der Versorgungsspannung ermittelt werden.

Diese Aufgabe wird durch die Gegenstände und das Verfahren gemäß der unabhängigen Ansprüche gelöst.

Gemäß einem Aspekt wird eine Vorrichtung zur Messung bzw. Ermittlung eines Zustands eines elektrischen Schalters angegeben. Durch die Vorrichtung soll der Zustand des Schalters überwacht werden. Der elektrische Schalter ist insbesondere ein Leistungsschütz oder ein Relais.

Die Vorrichtung ist dazu ausgebildet und angeordnet eine Spannung an Hauptkontakten des elektrischen Schalters abzugreifen. Die Spannung soll direkt bzw. unmittelbar an den Hauptkontakten abgegriffen werden. Die Vorrichtung ist dazu ausgebildet zumindest teilweise in den Schalter integriert zu werden. Auf diese Weise können direkt Rückschlüsse auf den Zustand des Schalters gezogen werden (offen oder geschlossen). Der Zustand des Schalters kann ohne Zuhilfenahme der Versorgungsspannung ermittelt werden. Zusätzlich kann auch ein Verlust der Isolationsleistung (z.B. durch Bedampfung der Innenwand des Schalters oder durch äußere Einflüsse) detektiert werden. So kann auf effektive und sichere Art und Weise der Zustand des Schalters mit Hilfe der Vorrichtung ermittelt werden.

Gemäß der Erfindung weist die Vorrichtung eine erste HV-Leitung auf. Die Vorrichtung weist einen ersten Kontakt auf. Der erste Kontakt ist an der ersten HV-Leitung angeordnet. Die Vorrichtung weist eine zweite HV-Leitung auf. Die Vorrichtung weist einen zweiten Kontakt auf. Der zweite Kontakt ist an der zweiten HV-Leitung angeordnet.

Die Vorrichtung weist ferner wenigstens einen hochohmigen Widerstand auf. Der wenigstens eine hochohmige Widerstand ist dazu ausgebildet und angeordnet, den Stromfluss auf einer beliebigen HV-Leitung, also der ersten HV-Leitung oder der zweiten HV-Leitung, zu unterbrechen.

Die Vorrichtung weist nach einer Alternative der Erfindung wenigstens einen ersten hochohmigen Widerstand sowie wenigstens einen zweiten hochohmigen Widerstand auf. Vorzugsweise weist die Vorrichtung vier hochohmige Widerstände auf. Durch die Widerstände wird der Stromfluss auf den HV-Leitungen vorzugsweise unterbrochen.

Gemäß der Erfindung weist der jeweilige Widerstand einen Wert auf, der bei einem externen Kurzschluss der zwei HV-Leitungen einen maximalen Stromfluss von 1mA erlaubt. Der jeweilige Widerstand weist einen Wert von größer oder gleich 1 MOhm auf, beispielsweise ist R >> 1 MOhm. Durch den einfachen Aufbau der Vorrichtung kann auf kostengünstige und einfache Art und Weise der Zustand des Schalters überwacht werden.

Gemäß der Erfindung ist der erste Kontakt dazu vorgesehen direkt bzw. unmittelbar mit einem ersten Hauptkontakt des Schalters verbunden zu werden. Der zweite Kontakt ist dazu vorgesehen direkt bzw. unmittelbar mit einem zweiten Hauptkontakt des Schalters verbunden zu werden. Die Kontakte können dazu vorgesehen sein lösbar oder unlösbar mit den Hauptkontakten verbunden zu werden. Hilfskontakte zur Messung des Zustands des Schalters sind überflüssig. Somit wird eine besonders einfache und effektive Vorrichtung zur Verfügung gestellt.

Gemäß der Erfindung weist die Vorrichtung einen Träger auf. Der Träger kann ein Thermoplast aufweisen. Der Träger ist dazu vorgesehen und ausgebildet auf dem Schalter, innerhalb eines Gehäuses des Schalters angeordnet zu werden. Der erste und der zweite Kontakt und der jeweilige Widerstand sind auf dem Träger angeordnet. Ferner kann auch ein Teil der HV-Leitungen auf dem Träger angeordnet sein. Mit Hilfe des Trägers kann die Vorrichtung auf einfache Art auf dem Schalter angeordnet werden. Ferner wird durch den Träger eine einfache und sichere Verbindung zwischen den Kontakten der Vorrichtung und den Hauptkontakten des Schalters ermöglicht.

Gemäß einem Ausführungsbeispiel sind die Kontakte dazu ausgebildet mit den Hauptkontakten verlötet zu werden. Somit wird eine besonders sichere Verbindung zwischen den Kontakten der Vorrichtung und den Hauptkontakten ermöglicht.

Gemäß einem Aspekt wird ein elektrischer Schalter, beispielsweise ein Leistungsschütz oder ein Relais, beschrieben. Der Schalter weist die oben beschrieben Vorrichtung auf. Die Vorrichtung ist zumindest teilweise in den Schalter integriert. Die Vorrichtung weist wenigstens einen hochohmigen Widerstand, vorzugsweise zwei oder vier hochohmige Widerstände, auf.

Der Schalter weist ferner einen ersten äußeren Hauptkontakt und einen zweiten äußeren Hauptkontakt auf. Der Schalter weist ein Gehäuse auf. Die Hauptkontakte ragen zumindest teilweise aus einer Oberseite des Gehäuses heraus.

Der erste Kontakt und der zweite Kontakt ist jeweils mit einem Hauptkontakt direkt bzw. unmittelbar verbunden. Die Kontakte sind elektrisch und mechanisch direkt mit den Hauptkontakten verbunden. Das direkte Abgreifen der Spannung an den Hauptkontakten ermöglicht eine direkte Auswertung des Zustands des Schalters. Weitere Komponenten, wie beispielsweise Hilfskontakte, sind überflüssig.

Die Kontakte können lösbar oder unlösbar mit den Hauptkontakten verbunden sein. Vorzugsweise ist der jeweilige Hauptkontakt an einer äußeren Seite mit dem jeweiligen Kontakt verbunden. Auf diese Weise wird das Verkürzen einer Isolationsstrecke zwischen den Hauptkontakten vermieden. Die Spannung an den Hauptkontakten wird innerhalb des Gehäuses des elektrischen Schalters abgegriffen. Insbesondere ist die Vorrichtung zumindest teilweise innerhalb des Gehäuses angeordnet. Dies betrifft die Kontakte, die Widerstände sowie einen Teilbereich der HV-Leitungen. Das Anordnen der strombegrenzenden Widerstände innerhalb des Gehäuses erhöht die Sicherheit bei der Handhabung.

Gemäß einem Ausführungsbeispiel sind zwei Widerstände pro Hauptkontakt vorgesehen. Die Widerstände weisen einen Wert von wenigstens 1 MOhm auf. Die Widerstände weisen beispielsweise einen Wert R >> 1 MOhm auf. Die Widerstände sind dazu ausgebildet und angeordnet, den Stromfluss auf den HV-Leitungen zu unterbrechen. Auch ein versehentlicher Kurzschluss hat durch die hohen Widerstände keine Auswirkungen.

Gemäß einem Ausführungsbeispiel sind der erste Kontakt und der zweite Kontakt Schleifkontakte. Dadurch ist es möglich, eine lösbare Verbindung zwischen den Kontakten und den Hauptkontakten auszubilden. Dies ist insbesondere dann vorteilhaft wenn Verschleißteile des Schalters zu ersetzen bzw. zu reparieren sind und dafür die Verbindung zwischen der Vorrichtung und den Hauptkontakten gelöst werden muss.

Gemäß einem Ausführungsbeispiel sind der erste Kontakt und der zweite Kontakt fest und insbesondere unlösbar mit dem jeweiligen Hauptkontakt verbunden. Beispielsweise ist der erste Kontakt und der zweite Kontakt an dem jeweiligen Hauptkontakt angeschweißt oder angelötet. Damit kann eine besonders stabile Verbindung zwischen der Vorrichtung und dem Schalter zur Verfügung gestellt werden.

Gemäß einem Aspekt wird ein Verfahren zur Messung eines Zustands eines elektrischen Schalters beschrieben. Der Schalter entspricht dem oben beschriebenen Schalter. Alle Merkmale, die in Bezug auf den Schalter beschrieben wurden, finden auch für das Verfahren Anwendung und umgekehrt.

Das Verfahren weist die folgenden Schritte auf:
- Bereitstellen eines elektrischen Schalters, beispielsweise eine Leistungsschützes oder eines Relais. Der Schalter weist einen ersten äußeren Hauptkontakt und einen zweiten äußeren Hauptkontakt. Der Schalter wird vorzugsweise zunächst ohne ein Gehäuse bereitgestellt. Beispielsweise wird das Gehäuse in einem Verfahrensschritt zumindest teilweise abmontiert.
- Bereitstellen einer Vorrichtung zum Abgreifen einer Spannung an den Hauptkontakten. Die Vorrichtung entspricht der oben beschriebenen Vorrichtung. Alle Merkmale, die in Bezug auf die Vorrichtung beschrieben wurden, finden auch für das Verfahren Anwendung und umgekehrt. Die Vorrichtung weist einen ersten und zweiten Kontakt, wenigstens einen ersten und wenigstens einen zweiten hochohmigen Widerstand, und eine erste und zweite HV-Leitung auf.
- Direktes Verbinden des ersten Kontakts mit dem ersten Hauptkontakt sowie direktes Verbinden des zweiten Kontakts mit dem zweiten Hauptkontakt. Beispielsweise werden die Kontakte mit den Hauptkontakten verlötet oder an ihnen angeschweißt. Alternativ dazu können die konnte auch als Schleifkontakte ausgebildet sein. Vorzugsweise erfolgt die Verbindung zwischen Kontakt und Hauptkontakt an äußeren Seiten des Hauptkontakts.
- Anschließen der HV-Leitungen an einen A/D Wandler zur direkten Messung und Auswertung der Spannung an den Hauptkontakten.

Durch das Verfahren kann auf einfache und effektive Weise die Spannung direkt an den Hauptkontakten gemessen werden. Damit kann auf exakte Weise der Zustand des Schalters gemessen werden. Es wird dabei kein Einfluss auf die Löschfähigkeit des Schalters und somit auf dessen Performance genommen. Auch wird kein Einfluss auf die elektrische Isolationsstrecke genommen.

Gemäß der Erfindung weist die Vorrichtung einen Träger auf. Der Träger wird auf den Schalter, insbesondere eine Oberseite des Schalters, aufgesetzt. Durch den Träger wird eine direkte, vorzugsweise lösbare, Verbindung zwischen dem ersten und zweiten Kontakt und dem jeweiligen Hauptkontakt ermöglicht.

Gemäß der Erfindung weist der Schalter ein Gehäuse auf. Die Vorrichtung wird zumindest teilweise innerhalb des Gehäuses angeordnet. Zu diesem Zweck wird das Gehäuse in einem vorangehenden Schritt entfernt, um die Vorrichtung anzubringen. Anschließend wird das Gehäuse wieder angebracht. Durch das Anbringen der Vorrichtung innerhalb des Gehäuses wird die Sicherheit erhöht.

Gemäß einem Aspekt wird die Verwendung einer Vorrichtung zur Messung eines Zustands eines elektrischen Schalters beschrieben. Vorzugsweise wird die oben beschriebene Vorrichtung dafür eingesetzt. Alle Merkmale, die in Bezug auf die Vorrichtung beschrieben wurden, finden auch für die Verwendung Anwendung und umgekehrt. Durch die Vorrichtung soll der Zustand des oben beschrieben Schalters gemessen werden. Insbesondere dient die Vorrichtung als integrierter Spannungssensor zum direkten Abgriff der Spannung an den Hauptkontakten. Damit kann auf effektive und sichere Art und Weise der Zustand des Schalters ermittelt werden.

Die nachfolgend beschriebenen Zeichnungen sind nicht als maßstabsgetreu aufzufassen. Vielmehr können zur besseren Darstellung einzelne Dimensionen vergrößert, verkleinert oder auch verzerrt dargestellt sein.

Elemente, die einander gleichen oder die die gleiche Funktion übernehmen, sind mit gleichen Bezugszeichen bezeichnet.

Es zeigen:
- Figur 1: eine Schnittdarstellung eines elektrischen Schalters gemäß dem Stand der Technik,
- Figur 2: eine Vorrichtung zur Messung eines Zustands eines elektrischen Schalters gemäß einem ersten Ausführungsbeispiel,
- Figur 3: einen elektrischen Schalter mit der Vorrichtung gemäß Figur 3,
- Figur 4: einen Teilbereich eines elektrischen Schalters, gemäß einem Beispiel, das nicht zur Erfindung gehört,
- Figur 5: einen elektrischen Schalter mit einer Vorrichtung zur Messung eines Zustands des elektrischen Schalters gemäß einem Beispiel, das nicht zur Erfindung gehört.

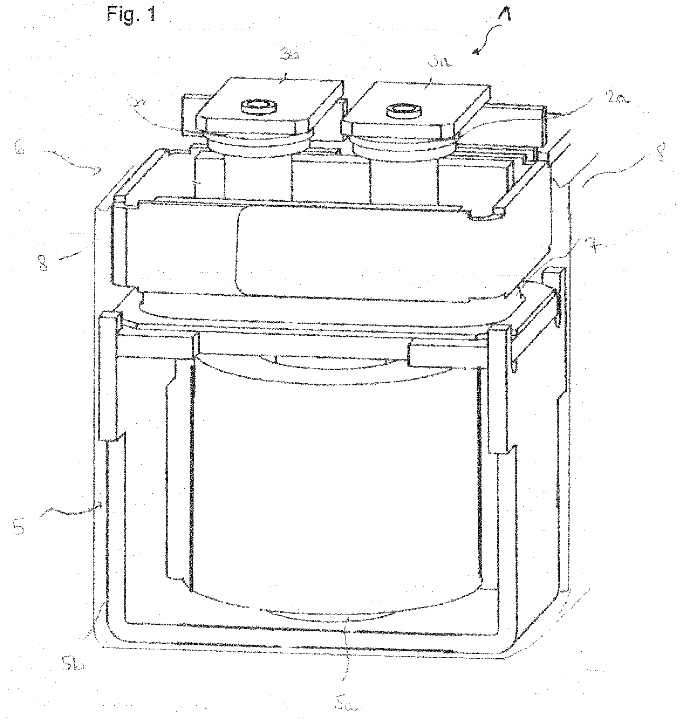

Die Figur 1 zeigt einen elektrischen Schalter gemäß dem Stand der Technik. Der elektrische Schalter ist beispielsweise als Leistungsschütz 1 bzw. als Relais ausgebildet.

Der elektrische Schalter 1 weist ein Gehäuse 8 auf (zur besseren Übersichtlichkeit ist das Gehäuse 8 in der Figur 1 nur in Teilbereichen dargestellt). In dem Gehäuse 8 sind eine Antriebseinheit 5 und eine Kontaktvorrichtung 6 angeordnet. Die Antriebseinheit 5 weist beispielsweise einen Magnetantrieb mit zumindest einer Spule 5a und einem Stößel 5b auf, der in der zumindest einen Spule 5a angeordnet ist. Die Spule 5a kann von außen mit einer Spannung beaufschlagt werden, um ein Magnetfeld in dem Stößel 5b zu erzeugen, wodurch der Stößel 5b axial entlang seiner Längsachse in Richtung der Kontaktvorrichtung 6 bewegbar ist.

Der elektrische Schalter 1 - insbesondere die Kontaktvorrichtung 6 - weist ein erstes Anschlusselement 3a, ein zweites Anschlusselement 3b, einen ersten äußeren Hauptkontakt 2a, einen zweiten äußeren Hauptkontakt 2b sowie ein schließendes Element 7 (bewegliche Kontaktbrücke 7) auf. Die Antriebseinheit 5 ist angeordnet und ausgebildet die Kontaktbrücke 7 zwischen einer ersten Stellung, in der die Kontaktbrücke 7 den ersten äußeren Hauptkontakt 2a und den zweiten äußeren Hauptkontakt 2b über einen ersten und einen zweiten inneren Kontakt (nicht explizit dargestellt) leitend verbindet, und einer zweiten Stellung, in der der erste äußere Hauptkontakt 2a und den zweite äußere Hauptkontakt 2b isoliert sind, umzuschalten.

Um den Zustand des elektrische Schalters 1 - offen oder geschlossen - zu ermitteln, wird in der Regel ein mechanischer Hilfskontakt, beispielsweise eine Hilfskontaktbrücke, der parallel zum schließenden Element 7 (Kontaktbrücke 7) angeordnet ist, benutzt um auf den Zustand der Hauptkontakte 2a, 2b zu folgern (nicht explizit dargestellt). Insbesondere wird eine Hilfskontaktbrücke in Form einer Plastikbrücke parallel zum schließenden Element 7 geführt. Die Hilfskontaktbrücke betätigt einen Mikroschalter bzw. einen Taster, dessen Signal dann "offen" oder "geschlossen" signalisiert.

Je nach Wahl des Mikroschalters ist ein Signal "normal offen", "normal geschlossen" oder ein Wechselkontakt realisierbar. Nachteil dieser Anordnung ist, dass Mikroschalter eine sehr begrenzte Lebensdauer haben. Zusätzlich befindet sich der Schalter in einer Umgebung, in der es sehr warm werden kann, was zusätzlich Ausfälle beschleunigt. In der Regel sind bei elektrischen Schaltern dieser Art Löschmagnete rund um die Kontakte angebracht, die eine Bogenlöschung begünstigen. Bei der Anbringung dieses Mikroschalters wird einer dieser Magneten aus Platzgründen weggelassen, was eine reduzierte Performance des elektrischen Schalters zur Folge hat (Bogenlöschfähigkeit).

Auch bekannt ist das Schließen eines verschleißarmen Schalters in Form von zwei übereinander liegenden Blechen (Hilfskontakte; nicht explizit dargestellt). Diese können dann sehr einfach extern ausgewertet werden. Insbesondere ist der Hilfskontakt geschlossen, wenn die Kontaktbrücke 7 in oberer Position ist. Ein Nachteil dieser Konstruktion ist, dass die Hilfskontakte sehr nah an den Hauptkontakten 2a, 2b gelagert sind. Hier kann es zu elektrischen Überschlägen vom Lastkreis auf die Auswerteeinheit des Steuerkreises kommen (Verringerung der elektrischen Isolationsstrecke).

Ein großer Nachteil der vorgenannten Lösungen ist, dass nicht der Zustand des Hauptkontaktes selbst, sondern der eines Hilfskontaktes ausgewertet wird. Die Situation eines einseitigen Schützklebers ist denkbar, in der der Hauptkontakt zwischen der oberen und unteren Anschlagsposition hängt. Der Hilfskontakt zeigt dabei entweder offen oder geschlossen an (je nach Höhe). Sollte sich durch Abschalten in einem besonders starken Fehlerfall die Brückenhalterung auflösen, so könnte auch "offen" signalisiert werden, obwohl die Brücke an den Kontakten klebt.

Um die oben beschriebenen Nachteile der im Stand der Technik bekannten Lösungen zur Erkennung der Schaltposition eines elektrischen Schalters zu umgehen, wird im Folgenden eine Vorrichtung zur Messung eines Zustands eines elektrischen Schalters beschrieben.

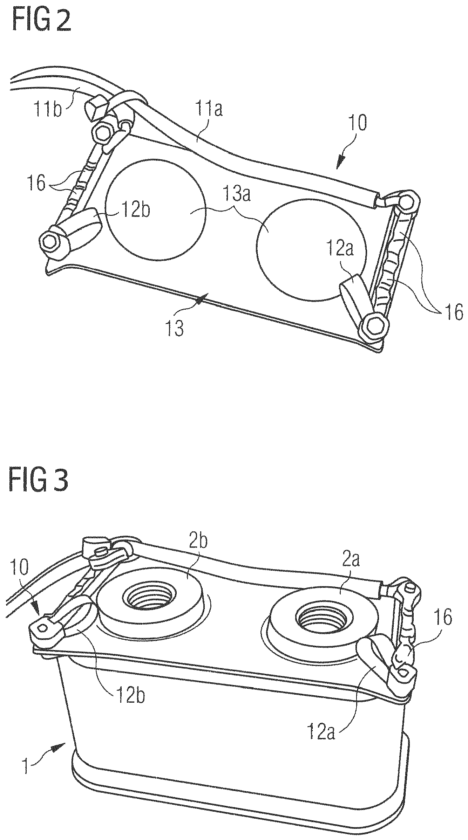

Die Figur 2 zeigt dabei eine Vorrichtung 10 zur Messung eines Zustands eines elektrischen Schalters 1 gemäß einem ersten Ausführungsbeispiel. Die Figur 3 zeigt den elektrischen Schalter 1 mit der Vorrichtung 10 aus der Figur 2.

Die Vorrichtung 10 ist dazu ausgebildet eine Spannung direkt an den Hauptkontakten 2a, 2b des elektrischen Schalters 1 ab zugreifen. Dabei ist die Vorrichtung 10 direkt bzw. unmittelbar mit den Hauptkontakten 2a, 2b elektrisch leitend verbunden. Die Vorrichtung 10 ist dazu vorgesehen zumindest teil weise innerhalb des Schalters 1, insbesondere innerhalb des Gehäuses 8, angeordnet zu werden. Die Vorrichtung 10 ist eine in den Schalter 1 zumindest teilweise integrierte Vorrichtung. Die Vorrichtung 10 stellt einen integrierten Spannungssensor dar.

Die Vorrichtung 10 weist einen ersten Kontakt 12a und einen zweiten Kontakt 12b auf. Die Kontakte 12a, 12b sind dazu ausgebildet und angeordnet direkt mit den Hauptkontakten 2a, 2b des Schalters 1 verbunden zu werden, um die an den Hauptkontakten 2a, 2b anliegende Spannung zu messen. In diesem Ausführungsbeispiel sind die Kontakte 12a, 12b Schleif- bzw. Gleitkontakte. Mit anderen Worten, die Kontakte 12a, 12b sind nicht fest bzw. unlösbar mit den Hauptkontakten 2a, 2b verbunden. Unlösbar bedeutet in diesem Zusammenhang, dass eine Verbindung nicht gelöst werden kann, ohne wenigstens eines der an der Verbindung beteiligten Bauteile dabei zu zerstören.

Die Vorrichtung 10 weist ferner eine erste HV-Leitung 11a sowie eine zweite HV-Leitung 11b auf. Die erste HV-Leitung 11a, insbesondere ein erstes Ende der ersten HV-Leitung 11a, ist mit dem ersten Kontakt 12a elektrisch verbunden. Der erste Kontakt 12a ist am ersten Ende der ersten HV-Leitung 11a angeordnet. Die zweite HV-Leitung 11b, insbesondere ein erstes Ende der zweiten HV-Leitung 11b, ist mit dem zweiten Kontakt 12b elektrisch verbunden. Der zweite Kontakt 12b ist am ersten Ende der zweiten HV-Leitung 11b angeordnet. Ein zweites Ende der ersten HV-Leitung 11a und der zweiten HV-Leitung 11b ist beispielsweise mit einem A/D Wandler verbunden (nicht explizit dargestellt).

Die Vorrichtung 10 weist wenigstens zwei hochohmige Widerstände 16 auf. In diesem Ausführungsbeispiel sind vier hochohmige Widerstände 16 vorgesehen, zwei Widerstände 16 für jeden Hauptkontakt 2a, 2b. Die Widerstände weisen einen Wert von mindestens 1 MOhm auf. Auch größere Werte sind vorstellbar. Der Wert der Widerstände kann auch >> 1 MOhm betragen.

Durch geeignete hochohmige Widerstände 16 wird der Stromfluss auf den HV-Leitungen 11a, 11b praktisch unterbrochen. Bei Betriebsspannungen bis max. 1000 V können nur Ströme << 1mA auftreten. Auch ein versehentlicher Kurzschluss hat durch die hohen Widerstände keine Auswirkungen.

Die Vorrichtung 10 weist ferner einen Träger 13 auf. Der Träger 13 weist vorzugsweise ein Thermoplast auf. Beispielsweise weist der Träger 13 Polytetrafluorethylen (Teflon) auf. Die Kontakte 12a, 12b, die Widerstände 18 sowie Teilbereiche der HV-Leitungen 11a, 11b sind auf dem Träger 13 angeordnet, beispielsweise angeschraubt. Der Träger 13 ist dazu ausgebildet, auf den elektrischen Schalter 1, beispielsweise einen Leistungsschütz, aufgesetzt zu werden. Der Träger 13 weist Aussparungen 13a auf. Insbesondere weist der Träger 13 zwei Aussparungen 13a auf. Die Aussparungen 13a sind kreisförmig ausgebildet. Die Aussparungen 13a sind zur Aufnahme der Hauptkontakte 2a, 2b in die Aussparungen 13a vorgesehen. Ein Durchmesser der jeweiligen Aussparung 13 ist dabei größer als ein Durchmesser des jeweiligen Hauptkontakts 2a, 2b.

Die auf dem elektrischen Schalter 1 angeordnete Vorrichtung 10 ist in der Figur 3 dargestellt. Die Vorrichtung 10, insbesondere der Träger 13 mit den Kontakten 12a, 12b und den Widerständen 16, ist dabei an einer Oberseite des Schalters 1 angeordnet. Der Träger 10 ist auf der Oberseite aufgesetzt. Eine Grundfläche des Trägers 13 ist größer als eine Grundfläche der Kontaktvorrichtung 6 bzw. eines oberen Teilbereichs des Schalters 1. Somit ragt der Träger 13 in radialer Richtung über die Oberseite des Schalters 1 hinaus.

Die Hauptkontakte 2a, 2b sind in den Aussparungen 13a des Trägers 13 gelagert und ragen aus den Aussparungen 13a heraus. Der Träger 13 ist innerhalb des Gehäuses 8 des Schalters 1 (nicht explizit dargestellt) angeordnet. Damit stellt die Vorrichtung 10 einen in den Schalter 1 integrierten Spannungssensor dar.

Die Kontakte 12a, 12b sind direkt mit dem Hauptkontakten 2a, 2b verbunden, so dass die Spannung an den Hauptkontakten 2a, 2b direkt abgegriffen werden kann. Der Abgriff der Spannung erfolgt an äußeren Seiten der Hauptkontakte 2a, 2b, damit es zu keiner Verkürzung der Isolationstrecke zwischen den Hauptkontakten 2a, 2b kommt. Da die Spannung an den Hauptkontakten 2a, 2b direkt ausgewertet werden kann, können direkt Rückschlüsse auf den Zustand des Schalters 1 gezogen werden (offen oder geschlossen). Zusätzlich kann ein Verlust der Isolationsleistung (z.B. durch Bedampfung der Innenwand des Schalters 1 oder durch äußere Einflüsse) detektiert werden. Die HV-Leitungen 11a, 11b werden an einer gemeinsamen Stelle aus dem Gehäuse 8 des Schalters 1 herausgeführt, um mit dem A/D-Wandler verbunden zu werden.

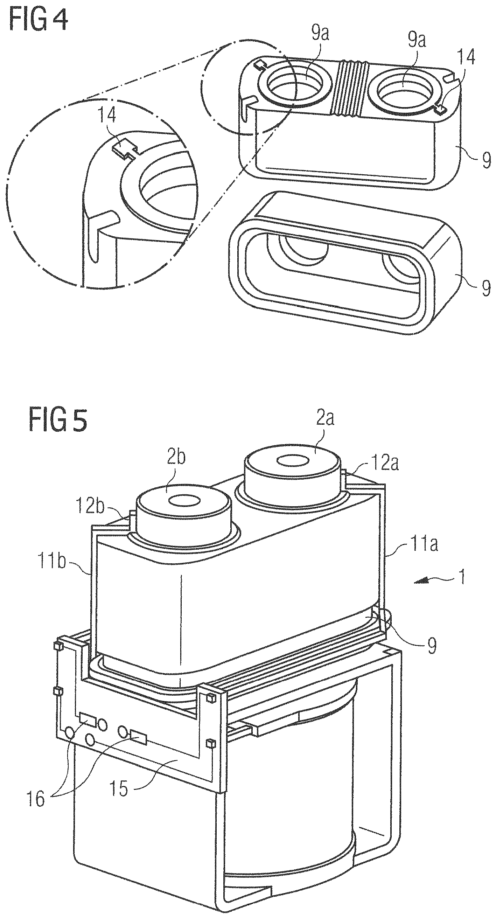

Gemäß einem Beispiel, das nicht zur Erfindung gehört, zeigt die Figur 4 einen Teilbereich, insbesondere einen oberen Teilbereich, eines elektrischen Schalters 1. Die Figur 5 zeigt ferner einen elektrischen Schalter 1 mit einer Vorrichtung 10 zur Messung eines Zustands des elektrischen Schalters 1 gemäß einem Beispiel, das nicht zur Erfindung gehört.

Der in der Figur 4 dargestellte Teilbereich ist beispielsweise ein innerer Gehäuseteil 9 des Schalters 1. Der innere Gehäuseteil 9 weist vorzugsweise eine Keramik auf. Der innere Gehäuseteil 9 ist dazu ausgebildet, die Kontaktvorrichtung 6 aufzunehmen. Der innere Gehäuseteil 9 weist zwei Aussparungen 9a auf. Die Aussparungen 9a sind kreisförmig ausgebildet und dazu ausgelegt die Hauptkontakte 2a, 2b aufzunehmen. Die Hauptkontakte 2a, 2b werden durch die Aussparungen 9a hindurchgeführt (siehe Figur 5).

Der innere Gehäuseteil 9 weist Lötanschlüsse 14 auf. Insbesondere ist jeweils ein Lötanschluss 14 angrenzend zu einer Aussparung 9a ausgebildet. Die Lötanschlüsse sind direkt in den inneren Gehäuseteil 9 bzw. in die Keramik des inneren Gehäuseteils 9 integriert.

Der jeweilige Lötanschluss 14 ist dazu ausgebildet und ausgelegt, die Kontakte 12a, 12b der Vorrichtung 10 direkt elektrisch leitend mit den Hauptkontakten 2a, 2b zu verbinden, insbesondere zu verlöten. Der jeweilige Lötanschluss 14 stellt folglich einen Bereich dar, in welchem die Kontakte 12a, 12b mit dem Hauptkontakten 2a, 2b verlötet werden. Durch die direkte Lötverbindung zwischen den Kontakten 12a, 12b und den Hauptkontakten 2a, 2b kann ein wie in den Figuren 2 und 3 dargestellter Träger 13 komplett entfallen (siehe Figur 5).

In Figur 5 ist die Vorrichtung 10 auf den Schalter 1 aufgebracht. Die Kontakte 12a, 12b sind über die Lötanschlüsse 14 direkt mit dem Hauptkontakten 2a, 2b fest verbunden, insbesondere verlötet. Die Kontakte 12a, 12b sind an äußeren Seiten der Hauptkontakte 2a, 2b angeordnet. Der Abgriff der Spannung erfolgt an den äußeren Seiten der Hauptkontakte 2a, 2b, damit es zu keiner Verkürzung der Isolationstrecke zwischen den Hauptkontakten 2a, 2b kommt.

Die HV-Leitungen 11a, 11b sind in vertikaler Richtung am Gehäuseteil 9 entlanggeführt. An einem unteren Ende des inneren Gehäuseteils 9 sind die HV-Leitungen 11a, 11b in horizontaler Richtung am Gehäuseteil 9 entlanggeführt. Die HV-Leitungen 11a, 11b werden an einer Leiterplatte 15 zusammengeführt. Die Leiterplatte 15 ist an einer Stirnfläche des Schalters 1 innerhalb des Gehäuses 8 des Schalters 1 angeordnet. Mit anderen Worten, die Leiterplatte 15 ist an einer stirnseitigen Innenfläche des Schalters 1 befestigt.

Auf der Leiterplatte 15 sind die oben beschriebenen Widerstände 16 ausgebildet. Die Widerstände 16 sind folglich innerhalb des Gehäuses 8 angeordnet. Das Anbringen der strombegrenzenden Widerstände 16 innerhalb des Gehäuses 8 erhöht die Sicherheit bei der Handhabung. Eine Anbringung der Widerstände 16 nahe des A/D Wandlers ist insbesondere nicht möglich, da die HV-Leitungen 11a, 11b sonst vom Schalter 1 bis dorthin nicht nur das Potenzial sondern auch die volle Kurzschlussleistung der Batterie tragen. Von der Leiterplatte 15 wieder weggeführte Bereiche der HV-Leitungen 11a, 11b werden an einer vorbestimmten Stelle aus dem Gehäuse 8 herausgeführt (nicht explizit dargestellt) und anschließend mit dem A/D-Wandler verbunden.

Die in den Zusammenhang mit den Figuren 2 bis 5 beschriebenen Vorrichtungen 10 zur Zustandsmessung eines elektrischen Schalters 1 haben den Vorteil, dass
i) ein direkter Abgriff der Spannung an den Hauptkontakten 2a, 2b und damit eine direkte Auswertung ermöglicht ist. Es sind insbesondere keine Hilfskontakte und keine Auswertung des Zustands der Hilfskontakte erforderlich;
ii) die Vorrichtung sehr verschleißarm ist, da keine beweglichen Elemente vorgesehen sind;
iii) Die Vorrichtung keinen Einfluss auf die Löschfähigkeit des Schalters 1 nimmt. Es ist kein platzbedingtes Wegfallen von Löschmagneten erforderlich;
iv) Die Vorrichtung keinen Einfluss auf die elektrische Isolationsstrecke nimmt;
v) die Möglichkeit der exakteren Auswertung (nicht nur 1 oder 0 für offen oder geschlossen) sondern auch ein Detektieren von Leckströmen durch sinkenden Isolationswiderstand im offenen Zustand gegeben ist.

Im Folgenden wird ein Verfahren zur Messung eines Zustands eines elektrischen Schalters 1 beschrieben. Der elektrische Schalter 1 ist vorzugsweise als Leistungsschütz oder als Relais ausgebildet. Der elektrische Schalter 1 entspricht beispielsweise dem in Zusammenhang mit der Figur 1 beschriebenen Schalter 1.

In einem ersten Schritt wird der elektrische Schalter 1 bereitgestellt. Der Schalter 1 weist einen ersten äußeren Hauptkontakt 2a sowie einen zweiten äußeren Hauptkontakt 2b auf. Der Schalter 1 weist ein Gehäuse 8 auf. Das Gehäuse 8 ist dazu vorgesehen die Komponenten des Schalters 1, insbesondere eine Antriebseinheit 5 und eine Kontaktvorrichtung 6 aufzunehmen. Sind Antriebseinheit 5 und Kontaktvorrichtung 6 in dem Gehäuse 8 angeordnet, so ragen die Hauptkontakte 2a, 2b zumindest teilweise aus dem Gehäuse 8 heraus. Zur Durchführung der weiteren Schritte des Verfahrens wird der Schalter 1 zunächst ohne das Gehäuse 8 bereitgestellt.

In einem weiteren Schritt wird eine Vorrichtung 10 zum Abgreifen einer Spannung an den Hauptkontakten 2a, 2b bereitgestellt. Die Vorrichtung 10 entspricht vorzugsweise einer der in Zusammenhang mit den Figuren 2 bis 5 beschriebenen Vorrichtungen. Die Vorrichtung weist einen ersten und zweiten Kontakt 12a, 12b, vier hochohmige Widerstände 16 sowie eine erste und zweite HV-Leitung 11a, 11b auf. In dem Ausführungsbeispiel gemäß Figuren 2 und 3 weist die Vorrichtung ferner einen Träger 13 auf. Alternativ dazu kann die Vorrichtung auch ohne einen Träger 13 ausgebildet sein (Figuren 4 und 5).

In einem weiteren Schritt wird der erste Kontakt 12a direkt mit dem ersten Hauptkontakt 2a verbunden. Ferner wird der zweite Kontakt 12b direkt mit dem zweiten Hauptkontakt 2b verbunden.

Dies erfolgt entweder durch Aufsetzen des Trägers 13 auf den elektrischen Schalter 1 und Ausbildung eines Schleifkontakts zwischen den Kontakten 12a, 12b und den Hauptkontakten 2a, 2b (siehe Figuren 2 und 3).

Alternativ dazu können die Kontakte 12a, 12b auch mit den Hauptkontakten 2a, 2b verlötet werden (Figuren 4 und 5). In diesem Fall werden in einem vorangehenden Schritt Lötanschlüsse 14 an einem inneren Gehäuseteil 9 des Schalters 1 bereitgestellt. Die HV-Leitungen 11a, 11b werden dann an dem inneren Gehäuseteil 9 des Schalters 9 entlang zu einer Leiterplatte 15 geführt. Von der Leiterplatte 15 aus werden die HV-Leitungen 11a, 11b nach dem Aufbringen des Gehäuses 8 auf dem Schalter 1 aus dem Gehäuse 8 herausgeführt.

In einem weiteren Schritt wird das Gehäuse 8 bereitgestellt und über den oben beschriebenen Komponenten angeordnet. Gemäß dem in den Figuren 2 und 3 beschriebenen Ausführungsbeispiel werden die HV-Leitungen 11a, 11b an einem gemeinsamen Punkt an einer Oberseite des Schalters 1 aus dem Gehäuse 8 herausgeführt. Eine entsprechende Aussparung ist an dem Gehäuse 8 vorgesehen.

Gemäß dem in den Figuren 4 und 5 beschriebenen Ausführungsbeispiel werden die HV-Leitungen 11a, 1b von der Leiterplatte 15 ausgehend beispielsweise aus einer Stirnseite des Schalters 1 aus dem Gehäuse 8 herausgeführt. Eine entsprechende Aussparung ist an dem Gehäuse 8 vorgesehen.

In einem weiteren Schritt werden die HV-Leitungen 11a, 11b an einen A/D Wandler angeschlossen.

Durch das oben beschriebene Verfahren ist ein direkter Abgriff der Spannung an den Hauptkontakten 2a, 2b und damit eine direkte Auswertung möglich. Der Zustand des Schalters 1 kann damit auf sichere und effektive Weise ermittelt werden. Die Performance des elektrischen Schalters 1 wird nicht beeinträchtigt. Ferner ist es auch möglich Leckströme im offenen Zustand des Schalters 1 zu detektieren.

Die Beschreibung der hier angegebenen Gegenstände ist nicht auf die einzelnen speziellen Ausführungsformen beschränkt.

### Bezugszeichenliste

- 1: Elektrischer Schalter
- 2a: Erster äußerer Hauptkontakt
- 2b: Zweiter äußerer Hauptkontakt
- 3a: Erstes Anschlusselement
- 3b: Zweites Anschlusselement

- 5: Antriebseinheit
- 6: Kontaktvorrichtung
- 7: Schließendes Element / Kontaktbrücke
- 8: Gehäuse
- 9: Innerer Gehäuseteil
- 9a: Aussparung

- 10: Vorrichtung
- 11a: Erste HV-Leitung
- 11b: Zweite HV-Leitung
- 12a: Erster Kontakt
- 12b: Zweiter Kontakt
- 13: Träger
- 13a: Aussparung
- 14: Lötanschluss
- 15: Leiterplatte
- 16: Widerstand

## Patentansprüche

1. Vorrichtung (10) zur Messung eines Zustands eines elektrischen Schalters (1), wobei die Vorrichtung (10) dazu ausgebildet ist, innerhalb eines Gehäuses (8) des elektrischen Schalters (1) eine Spannung an Hauptkontakten (2a, 2b) des elektrischen Schalters (1), die teilweise aus einer Oberseite des Gehäuses herausragen, abzugreifen, um Rückschlüsse auf einen Zustand des Schalters, insbesondere offen oder geschlossen, ziehen zu können, die Vorrichtung aufweisend
- eine erste HV-Leitung (11a) mit einem ersten Kontakt (12a),
- eine zweite HV-Leitung (11b) mit einem zweiten Kontakt (12b),
- wenigstens einen hochohmigen Widerstand (16), wobei der jeweilige hochohmige Widerstand einen Widerstandswert von mindestens 1 MOhm aufweist, und dazu ausgebildet ist, einen Stromfluss auf einer der HV-Leitungen (11a, 11b) zu unterbrechen, wobei der erste Kontakt (12a) und der zweite Kontakt (12b) dazu ausgebildet sind, direkt mit den Hauptkontakten (2a, 2b) des elektrischen Schalters (1) verbunden zu werden, und
- einen Träger (13), wobei der erste und der zweite Kontakt (12a, 12b) und der wenigstens eine hochohmige Widerstand (16) auf dem Träger (13) angeordnet sind und der Träger (13) kreisförmige Aussparungen (13a) aufweist, die zur Aufnahme der Hauptkontakte (2a, 2b) vorgesehen sind, so dass die Hauptkontakte (2a, 2b) in den Aussparungen (13a) gelagert werden und aus den Aussparungen (13a) herausragen.

2. Vorrichtung (10) zur Messung eines Zustands eines elektrischen Schalters (1), wobei die Vorrichtung (10) dazu ausgebildet ist, innerhalb eines Gehäuses (8) des elektrischen Schalters (1) eine Spannung an Hauptkontakten (2a, 2b) des elektrischen Schalters (1), die teilweise aus einer Oberseite des Gehäuses herausragen, abzugreifen, um Rückschlüsse auf einen Zustand des Schalters, insbesondere offen oder geschlossen, ziehen zu können, die Vorrichtung aufweisend
- eine erste HV-Leitung (11a) mit einem ersten Kontakt (12a),
- eine zweite HV-Leitung (11b) mit einem zweiten Kontakt (12b),
- wenigstens einen ersten hochohmigen Widerstand (16), wobei der jeweilige erste hochohmige Widerstand einen Widerstandswert von mindestens 1 MOhm aufweist, und wenigstens einen zweiten hochohmigen Widerstand (16), wobei der jeweilige zweite hochohmige Widerstand einen Widerstandswert von mindestens 1 MOhm aufweist, wobei der jeweilige Widerstand (16) dazu ausgebildet ist, einen Stromfluss auf der jeweiligen HV-Leitung (11a, 11b) zu unterbrechen, und
- einen Träger (13), wobei der erste und der zweite Kontakt (12a, 12b) und der wenigstens eine erste und wenigstens eine zweite hochohmige Widerstand (16) auf dem Träger (13) angeordnet sind und der Träger (13) kreisförmige Aussparungen (13a) aufweist, die zur Aufnahme der Hauptkontakte (2a, 2b) vorgesehen sind, so dass die Hauptkontakte (2a, 2b) in den Aussparungen (13a) gelagert werden und aus den Aussparungen (13a) herausragen.

3. Vorrichtung (10) nach Anspruch 2,
wobei die Vorrichtung den wenigstens einen ersten hochohmigen Widerstand (16) und den wenigstens einen zweiten hochohmigen Widerstand (16) aufweist und der erste Kontakt (12a) und der zweite Kontakt (12b) dazu ausgebildet sind, direkt mit den Hauptkontakten (2a, 2b) des elektrischen Schalters (1) verbunden zu werden.

4. Elektrischer Schalter (1) aufweisend
- einen ersten Hauptkontakt (2a),
- einen zweiten Hauptkontakt (2b),
- ein Gehäuse (8),
- eine Vorrichtung (10) gemäß einem der Ansprüche 2 und 3 zur Messung eines Zustands des elektrischen Schalters (1), wobei die Vorrichtung (10) dazu ausgebildet ist eine Spannung an den Hauptkontakten (2a, 2b) des elektrischen Schalters (1), die teilweise aus einer Oberseite des Gehäuses herausragen, abzugreifen und die erste HV-Leitung (11a) mit dem ersten Kontakt (12a), die zweite HV-Leitung (11b) mit dem zweiten Kontakt (12b) und den wenigstens einen ersten hochohmigen Widerstand (16) und den wenigstens einen zweiten hochohmigen Widerstand (16) aufweist,
wobei der erste Kontakt (12a) und der zweite Kontakt (12b) jeweils mit einem Hauptkontakt (2a, 2b) direkt verbunden ist,
wobei die Spannung an den Hauptkontakten (2a, 2b) innerhalb des Gehäuses (8) des elektrischen Schalters (1) abgegriffen wird und
wobei die Hauptkontakte (2a, 2b) in den Aussparungen (13a) des Trägers (13) der Vorrichtung (10) gelagert sind und aus den Aussparungen (13a) herausragen.

5. Elektrischer Schalter (1) nach Anspruch 4,
wobei der wenigstens eine erste und der wenigstens eine zweite hochohmige Widerstand (16) innerhalb des Gehäuses (8) angeordnet sind.

6. Elektrischer Schalter (1) nach Anspruch 4 oder 5,
wobei zwei hochohmige Widerstände (16) pro Hauptkontakt (2a, 2b) vorgesehen sind.

7. Elektrischer Schalter (1) nach einem der Ansprüche 4 bis 6,
wobei der erste Kontakt (12a) und der zweite Kontakt (12b) Schleifkontakte sind.

8. Elektrischer Schalter (1) nach einem der Ansprüche 4 bis 6,
wobei der erste Kontakt (12a) und der zweite Kontakt (12b) fest mit dem jeweiligen Hauptkontakt (2a, 2b) verbunden sind.

9. Elektrischer Schalter (1) nach Anspruch 8,
wobei der erste Kontakt (12a) und der zweite Kontakt (12b) an dem jeweiligen Hauptkontakt (2a, 2b) angeschweißt oder angelötet ist.

10. Verfahren zur Messung eines Zustands eines elektrischen Schalters (1), wobei der elektrische Schalter (1) gemäß einem der Ansprüche 4 bis 9 ausgebildet ist, aufweisend die folgenden Schritte:
- Bereitstellen des elektrischen Schalters (1) aufweisend den ersten Hauptkontakt (2a) und den zweiten Hauptkontakt (2b) und die Vorrichtung (10) zum Abgreifen einer Spannung an den Hauptkontakten (2a, 2b), wobei die Vorrichtung (10) den ersten und zweiten Kontakt (12a, 12b), den wenigstens einen ersten hochohmigen Widerstand (16) und den wenigstens einen zweiten hochohmigen Widerstand (16) und die erste und zweite HV-Leitung (11a, 11b) aufweist,
- Direktes Verbinden des ersten Kontakts (12a) mit dem ersten Hauptkontakt (2a),
- Direktes Verbinden des zweiten Kontakts (12b) mit dem zweiten Hauptkontakt (2b),
- Anschließen der HV-Leitungen (11a, 11b) an einen A/D Wandler.

11. Verfahren nach Anspruch 10,
wobei der erste und zweite Kontakt (12a, 12b) an dem jeweiligen Hauptkontakt (2a, 2b) angeschweißt oder angelötet wird.

12. Verfahren nach Anspruch 10,
wobei der Träger (13) auf den Schalter (1) aufgesetzt wird zur direkten Verbindung zwischen dem ersten und zweiten Kontakt (12a, 12b) und dem jeweiligen Hauptkontakt (2a, 2b) .

13. Verfahren nach einem der Ansprüche 10 bis 12,
wobei der Schalter (1) ein Gehäuse (8) aufweist, und wobei die Vorrichtung (10) zumindest teilweise innerhalb des Gehäuses (8) angeordnet wird.

## Claims

1. An apparatus (10) for measuring a state of an electrical switch (1), wherein the apparatus (10) is configured to tap, inside a housing (8) of the electrical switch (1), a voltage at main contacts (2a, 2b) of the electrical switch (1), which partly project out of a top side of the housing, for making conclusions about the state of the switch 1, in particular open or closed,
the apparatus comprising
- a first HV line (11a) comprising a first contact (12a),
- a second HV line (11b) comprising a second contact (12b),
- at least one high-impedance resistor (16), wherein the respective high-impedance resistor (16) has an impedance value of at least 1 MOhm and is configured to interrupt a flow of current on one of the HV lines (11a, 11b), wherein the first contact (12a) and the second contact (12b) are configured to be connected directly to the main contacts (2a, 2b) of the electrical switch (1), and
- a carrier (13), wherein the first and the second contact (12a, 12b) and the at least one high-impedance resistor (16) are arranged on the carrier (13) and the carrier (13) comprises circular recesses (13a) provided to receive the main contacts (2a, 2b), so that the main contacts (2a, 2b) are mounted in the recesses (13a) and project out of the recesses (13a).

2. An apparatus (10) for measuring a state of an electrical switch (1), wherein the apparatus (10) is configured to tap, inside a housing (8) of the electrical switch (1), a voltage at main contacts (2a, 2b) of the electrical switch (1), which partly project out of a top side of the housing, for making conclusions about the state of the switch 1, in particular open or closed,
the apparatus comprising
- a first HV line (11a) comprising a first contact (12a),
- a second HV line (11b) comprising a second contact (12b),
- at least one first high-impedance resistor (16), wherein the respective first high-impedance resistor (16) has an impedance value of at least 1 MOhm, and at least one second high-impedance resistor (16), wherein the respective second high-impedance resistor (16) has an impedance value of at least 1 MOhm, wherein the respective resistor (16) is configured to interrupt a flow of current on the respective HV line (11a, 11b), and
- a carrier (13), wherein the first and the second contact (12a, 12b) and the at least one high-impedance resistor (16) are arranged on the carrier (13) and the carrier (13) comprises circular recesses (13a) provided to receive the main contacts (2a, 2b), so that the main contacts (2a, 2b) are mounted in the recesses (13a) and project out of the recesses (13a).

3. The apparatus (10) according to claim 2,
wherein the apparatus comprises the at least one first high-impedance resistor (16) and the at least one second high-impedance resistor (16) and the first contact (12a) and the second contact (12b) are configured to be connected directly to the main contacts (2a, 2b) of the electrical switch (1).

4. An electrical switch (1) comprising
- a first main contact (2a),
- a second main contact (2b),
- a housing (8),
- an apparatus (10) according to any of claims 2 and 3 for measuring a state of the electrical switch (1), wherein the apparatus (10) is configured to tap a voltage at the main contacts (2a, 2b) of the electrical switch (1), which partly project out of a top side of the housing, and comprises the first HV line (11a) with the first contact (12a), the second HV line (11b) with the second contact (12b) and the at least one first high-impedance resistor (16) and the at least one second high-impedance resistor (16),
wherein the first contact (12a) and the second contact (12b) are each connected directly to a main contact (2a, 2b),
wherein the voltage at the main contacts (2a, 2b) is tapped inside the housing (8) of the electrical switch (1), and
wherein the main contacts (2a, 2b) are mounted in the recesses (13a) oft he apparatus and project out of the recesses (13a).

5. The electrical switch (1) according to claim 4,
wherein the at least one first and the at least one second high-impedance resistor (16) are arranged inside the housing (8).

6. The electrical switch (1) according to claim 4 or 5,
wherein two high-impedance resistors (16) are provided for each main contact (2a, 2b).

7. The electrical switch (1) according to any of claims 4 to 6,
wherein the first contact (12a) and the second contact (12b) are sliding contacts.

8. The electrical switch (1) according to any of claims 4 to 6,
wherein the first contact (12a) and the second contact (12b) are fixedly connected to the respective main contact (2a, 2b).

9. The electrical switch (1) according to claim 8,
wherein the first contact (12a) and the second contact (12b) are welded or soldered to the respective main contact (2a, 2b).

10. A method for measuring a state of an electrical switch (1), wherein the electrical switch (1) is embodied according to any of claims 4 to 9, comprising the following steps:
- providing the electrical switch (1) comprising the first main contact (2a) and the second main contact (2b) and the apparatus (10) for tapping a voltage at the main contacts (2a, 2b), wherein the apparatus (10) comprises the first and second contact (12a, 12b), the at least one first high-impedance resistor (16) and the at least one second high-impedance resistor (16) and the first and second HV line (11a, 11b),
- directly connecting the first contact (12a) to the first main contact (2a),
- directly connecting the second contact (12b) to the second main contact (2b),
- linking the HV lines (11a, 11b) to an A/D converter.

11. The method according to claim 10,
wherein the first and second contact (12a, 12b) are welded or soldered to the respective main contact (2a, 2b).

12. The method according to claim 10,
wherein the carrier (13) is placed onto the switch (1) for direct connection between the first and second contact (12a, 12b) and the respective main contact (2a, 2b).

13. The method according to one of claims 10 to 12,
wherein the switch (1) comprises a housing (8), and wherein the apparatus (10) is arranged at least partly inside the housing (8).

## Revendications

1. Dispositif (10) pour mesurer un état d'un commutateur électrique (1), le dispositif (10) étant configuré pour prélever, à l'intérieur d'un boîtier (8) du commutateur électrique (1), une tension sur des contacts principaux (2a, 2b) du commutateur électrique (1) qui font partiellement saillie hors d'un côté supérieur du boîtier, afin de pouvoir tirer des conclusions à propos d'un état du commutateur, notamment ouvert ou fermé,
le dispositif comprenant
- un premier câble HT (11a) doté d'un premier contact (12a),
- un deuxième câble HT (11b) doté d'un deuxième contact (12b),
- au moins une résistance (16) à haute valeur ohmique, la résistance à haute valeur ohmique respective possédant une valeur de résistance d'au moins 1 Mohm, et étant configurée pour interrompre un flux de courant sur l'un des câbles HT (11a, 11b), le premier contact (12a) et le deuxième contact (12b) étant configurés pour être reliés directement aux contacts principaux (2a, 2b) du commutateur électrique (1), et
- un élément porteur (13), le premier et le deuxième contact (12a, 12b) et l'au moins une résistance (16) à haute valeur ohmique étant disposée sur l'élément porteur (13) et l'élément porteur (13) possédant des creux (13a) de forme circulaire, qui sont prévus pour accueillir les contacts principaux (2a, 2b), de sorte que les contacts principaux (2a, 2b) sont logés dans les creux (13a) et font saillie hors des creux (13a).

2. Dispositif (10) pour mesurer un état d'un commutateur électrique (1), le dispositif (10) étant configuré pour prélever, à l'intérieur d'un boîtier (8) du commutateur électrique (1), une tension sur des contacts principaux (2a, 2b) du commutateur électrique (1) qui font partiellement saillie hors d'un côté supérieur du boîtier, afin de pouvoir tirer des conclusions à propos d'un état du commutateur, notamment ouvert ou fermé,
le dispositif comprenant
- un premier câble HT (11a) doté d'un premier contact (12a),
- un deuxième câble HT (11b) doté d'un deuxième contact (12b),
- au moins une première résistance (16) à haute valeur ohmique, la première résistance à haute valeur ohmique respective possédant une valeur de résistance d'au moins 1 Mohm, et au moins une deuxième résistance (16) à haute valeur ohmique, la deuxième résistance à haute valeur ohmique respective possédant une valeur de résistance d'au moins 1 Mohm, la résistance (16) respective étant configurée pour interrompre un flux de courant sur le câble HT (11a, 11b) respectif, et
- un élément porteur (13), le premier et le deuxième contact (12a, 12b) et l'au moins une première et l'au moins une deuxième résistances (16) à haute valeur ohmique étant disposées sur l'élément porteur (13) et l'élément porteur (13) possédant des creux (13a) de forme circulaire, qui sont prévus pour accueillir les contacts principaux (2a, 2b), de sorte que les contacts principaux (2a, 2b) sont logés dans les creux (13a) et font saillie hors des creux (13a).

3. Dispositif (10) selon la revendication 2, le dispositif possédant l'au moins une première résistance (16) à haute valeur ohmique et l'au moins une deuxième résistance (16) à haute valeur ohmique et le premier contact (12a) et le deuxième contact (12b) étant configurés pour être reliés directement aux contacts principaux (2a, 2b) du commutateur électrique (1).

4. Commutateur électrique (1), comprenant
- un premier contact principal (2a),
- un deuxième contact principal (2b),
- un boîtier (8),
- un dispositif (10) selon l'une des revendications 2 et 3 pour mesurer un état du commutateur électrique (1), le dispositif (10) étant configuré pour prélever une tension sur les contacts principaux (2a, 2b) du commutateur électrique (1) qui font partiellement saillie hors d'un côté supérieur du boîtier, et possède le premier câble HT (11a) doté du premier contact (12a), le deuxième câble HT (11b) doté du deuxième contact (12b) ainsi que l'au moins une première résistance (16) à haute valeur ohmique et l'au moins une deuxième résistance (16) à haute valeur ohmique,
le premier contact (12a) et le deuxième contact (12b) étant respectivement reliés directement à un contact principal (2a, 2b),
la tension au niveau des contacts principaux (2a, 2b) étant prélevée à l'intérieur du boîtier (8) du commutateur électrique (1) et
les contacts principaux (2a, 2b) étant logés dans les creux (13a) de l'élément porteur (13) du dispositif (10) et faisant saillie hors des creux (13a).

5. Commutateur électrique (1) selon la revendication 4, l'au moins une première et l'au moins une deuxième résistances (16) à haute valeur ohmique étant disposées à l'intérieur du boîtier (8).

6. Commutateur électrique (1) selon la revendication 4 ou 5, deux résistances (16) à haute valeur ohmique étant prévues par contact principal (2a, 2b).

7. Commutateur électrique (1) selon l'une des revendications 4 à 6, le premier contact (12a) et le deuxième contact (12b) étant des contacts à frottement.

8. Commutateur électrique (1) selon l'une des revendications 4 à 6, le premier contact (12a) et le deuxième contact (12b) étant reliés à demeure au contact principal (2a, 2b) respectif.

9. Commutateur électrique (1) selon la revendication 8, le premier contact (12a) et le deuxième contact (12b) étant soudés ou brasés au contact principal (2a, 2b) respectif.

10. Procédé pour mesurer un état d'un commutateur électrique (1), le commutateur électrique (1) étant configuré selon l'une des revendications 4 à 9, comprenant les étapes suivantes :
- fourniture d'un commutateur électrique (1) possédant un premier contact principal (2a) et un deuxième contact principal (2b) et du dispositif (10) pour prélever une tension sur les contacts principaux (2a, 2b), le dispositif (10) possédant le premier et le deuxième contacts (12a, 12b), l'au moins une première résistance (16) à haute valeur ohmique et l'au moins une deuxième résistance (16) à haute valeur ohmique ainsi que le premier et le deuxième câble HT (11a, 11b),
- connexion directe du premier contact (12a) au premier contact principal (2a),
- connexion directe du deuxième contact (12b) au deuxième contact principal (2b),
- raccordement des câbles HT (11a, 11b) à un convertisseur A/N.

11. Procédé selon la revendication 10, le premier et le deuxième contacts (12a, 12b) étant soudés ou brasés au contact principal (2a, 2b) respectif.

12. Procédé selon la revendication 10, l'élément porteur (13) étant posé sur le commutateur (1) en vue d'une connexion directe entre le premier et le deuxième contacts (12a, 12b) et le contact principal (2a, 2b) respectif.

13. Procédé selon l'une des revendications 10 à 12, le commutateur (1) possédant un boîtier (8), et le dispositif (10) étant au moins partiellement disposé à l'intérieur du boîtier (8).
